# DEMANDE DE BREVET EUROPEEN

(11) **EP 0 834 747 A2**
(43) Date de publication de la demande: **08.04.1998**
(21) Numéro de dépôt: 97402122.2
(22) Date de dépôt: 12.09.1997
(51) Int. Cl.: G01R 33/38

(54) **Dispositif d'examen d'un volume de faible profondeur par resonance magnétique nucléaire**

(30) Priorité: 01.10.1996 FR 9611943
(71) Demandeur: L'OREAL, 75008 Paris (FR)
(72) Inventeur: Querleux, Bernard, 94170 Le Perreux (FR); Saint-Jalmes, Hervé, 75001 Paris (FR)
(74) Mandataire: Boulard, Denis

(57) **Abrégé**

L'invention concerne un dispositif d'examen (50) d'un volume (1) de faible profondeur, par résonance magnétique nucléaire, comportant : des moyens (4) pour créer un champ magnétique statique homogène B₀ dans lequel est placé le volume à examiner ; un système de gradients de champ magnétique (5) pour créer des gradients de champ magnétique dans les trois directions de l'espace ; un système d'émission/réception radiofréquence (6), caractérisé en ce que les moyens pour créer le champ magnétique B₀, le système de gradients de champ, et le système d'émission/réception radiofréquence sont situés d'un même côté d'une surface ouverte tandis que le volume à examiner est situé de l'autre côté de la surface.

Application à l'imagerie par résonance magnétique.

## Description

L'invention concerne un dispositif d'examen d'un volume de faible profondeur par résonance magnétique nucléaire. L'invention trouve application, mais non exclusivement, dans l'imagerie et la spectroscopie par résonance magnétique nucléaire, notamment dans le domaine médical (dermatologie), cosmétique, agro-alimentaire, etc.. L'invention est tout particulièrement avantageuse pour l'observation de zones superficielles d'un objet qui peut être très volumineux, notamment dans le cadre de l'étude de la peau in vivo, organe superficiel de faible épaisseur. De la même manière, un tel dispositif est utilisable notamment pour un examen, de l'oeil, de l'oreille interne, d'une portion superficielle du cerveau, ainsi que de tout autre organe de faible profondeur.

Au sens de la présente invention, l'examen d'un volume de faible profondeur peut aller d'un examen de surface (par exemple, d'une profondeur de quelques mm pour un examen de la peau) jusqu'à un volume de profondeur pouvant aller jusqu'à quelques cm). le volume de la région à examiner peut varier de quelques cm³ à quelques centaines de cm³.

Les appareils de RMN sont désormais largement utilisés en routine clinique. Ils permettent notamment de visualiser pratiquement tous les organes du corps humain. De tels appareils mettent en oeuvre un champ magnétique statique créé par un aimant dont la technologie dépend essentiellement de l'intensité souhaitée. Des champs magnétiques créés par des bobines de gradients de champ magnétique permettent la localisation spatiale de tous les points d'un volume. Des antennes radiofréquences permettent l'excitation et la réception d'un signal de RMN. La combinaison de ces champs permet d'obtenir des images anatomiques avec une résolution spatiale de l'ordre de 0,5 mm.

La réalisation pratique de ces dispositifs a, dès l'origine, conduit principalement à des appareils « corps entier » dans lesquels le patient est introduit. La zone d'intérêt que l'on souhaite observer est alors placée au centre de l'appareil qui entoure le patient.

Plus récemment, est apparu un nouveau type de machine, ne permettant plus d'étudier l'ensemble du corps humain, mais certaines régions spécifiques. Dans ce cas, le système de génération des champs magnétiques présente généralement un diamètre d'accès limité, interdisant l'introduction du patient en entier, mais néanmoins suffisant pour l'introduction de la partie du corps concernée. Un tel dispositif est décrit par exemple dans la demande de brevet Européen N° 176 353. Ces machines dédiées sont utilisées pour l'examen de zones spécifiques de relativement petite taille (genou, poignet, sein, etc.). Néanmoins, elles ne peuvent pas être utilisées lorsque l'on souhaite observer une petite zone sur un objet ou un corps d'encombrement plus important, comme par exemple lorsque l'on souhaite examiner un grain de beauté présent sur l'épaule d'un patient. Dans ce cas, il faut introduire le patient en entier dans un dispositif « corps entier ».

Dans les deux approches discutées ci-avant, la taille du système de génération du champ magnétique principal, des gradients de champ magnétique, ainsi que du système d'émission réception radiofréquence, est directement liée au volume du patient ou de l'objet dont il s'agit d'examiner une portion.

Le brevet des Etats-Unis d'Amérique 4 870 363 décrit un appareil dont le système pour créer le gradient de champ magnétique le long d'une direction de l'espace est entièrement situé du même côté d'une surface ouverte, tandis que le corps à examiner est situé de l'autre côté de la surface ouverte. Un tel système est intégré dans un dispositif de type corps entier dans lequel sont générés le champ magnétique principal, les gradients de champ dans les deux autres directions, ainsi que l'émission/réception radiofréquence.

Par ailleurs, tous les dispositifs évoqués précédemment présentent l'inconvénient d'être lourds, encombrants, et très coûteux.

Le document EP-A-0 512 345 décrit une méthode et un appareil pour réaliser de l'imagerie par résonance magnétique à haute résolution et à haute vitesse. Typiquement un tel dispositif comprend une ensemble de bobines pour générer un champ magnétique, un système d'émission/réception radio fréquence, un système de gradients de champ dans les trois directions de l'espace, tous ces éléments étant disposés du même côté de la surface à examiner, en l'occurrence la surface de la terre. Selon ce document, le champ magnétique est perpendiculaire à la surface examinée. Une telle configuration est limitée quant aux possibilités du système, en particulier, en termes d'encombrement du dispositif. Ceci est tout particulièrement vrai lorsque le dispositif doit être utilisé dans un cabinet médical par exemple. En outre, la mesure du signal est particulièrement compliquée en raison de la géométrie du système de réception rad iofréq uence.

Le brevet US-A-5 390 673 décrit un dispositif d'imagerie par résonance magnétique souffrant principalement d'un inconvénient selon lequel un gradient de champ est créé dans une seule direction de l'espace. En réalité, un tel système permet de réaliser de l'imagerie de surface à partir d'un champ non homogène, lequel champ est le résultat d'un champ homogène combiné avec un gradient naturel dans la direction perpendiculaire à la surface examinée. Les possibilités d'un tel système, tout particulièrement en termes de résolution d'image sont limitées. Par ailleurs, tout comme le dispositif du document précédent, le champ magnétique est perpendiculaire à la surface examinée.

Le dispositif décrit dans le document EP-A-0 186 998, outre le fait d'utiliser un champ magnétique perpendiculaire à la surface à examiner, utilise les mêmes moyens pour générer le champ magnétique homogène ainsi que les gradients de champ. Avec un tel dispositif, il est particulièrement difficile de faire de l'imagerie haute résolution. Par ailleurs, il est également extrêmement difficile de créer des gradients de champ dans les trois directions de l'espace, et de commuter rapidement.

Dans le document US-A-4 721 914, le système d'émission/réception est constitué d'une bobine disposée tout autour de la tête du patient. Par ailleurs, il n'y a pas de gradients de champ magnétique, ce qui limite l'utilisation d'un tel dispositif à la spectroscopie localisée.

Aussi, est-ce un des objets de la présente invention que de réaliser un appareil de RMN dans lequel il n'est plus nécessaire d'introduire le patient, en entier ou en partie, dans une structure fermée ou semi-fermée comme dans les dispositifs conventionnels, et qui ne présente pas les inconvénients mentionnés plus haut, en référence aux dispositifs de la technique antérieure, notamment, en termes d'encombrement, de résolution, de vitesse, de fiabilité, de complexité et de coût.

C'est un autre objet de la présente invention que de réaliser un dispositif dont la taille de la machine n'est plus liée à des contraintes anatomiques (diamètre du thorax ou du genou) d'un patient mais uniquement au volume de la zone à examiner, indépendamment de la taille du corps ou de l'objet auquel la zone appartient.

C'est encore un autre objet de la présente invention que de fournir un appareil d'examen compact, de relativement faible poids et encombrement, lui conférant ainsi une grande souplesse ainsi qu'une grande facilité d'utilisation, à un coût, par ailleurs, sans commune mesure avec le coût des dispositifs traditionnels.

D'autres objets de la présente invention apparaîtront de manière détaillée dans la description qui suit.

Selon l'invention, ces objets sont atteints au moyen d'un dispositif d'examen d'un volume de faible profondeur, par résonance magnétique nucléaire, comportant : des moyens pour créer un champ magnétique statique homogène B₀ dans lequel est placé le volume à examiner; un système de gradients de champ pour créer des gradients de champ magnétique dans les trois directions de l'espace; un système d'émission/réception radiofréquence, les moyens pour créer le champ magnétique B₀, le système de gradients de champ, et le système d'émission/réception radiofréquence étant situés d'un même côté d'une surface ouverte tandis que le volume à examiner est situé de l'autre côté de la surface. Selon l'invention, le champ magnétique B₀ a une direction parallèle à ladite surface ouverte. Avec un tel arrangement, on simplifie la mesure du signal, en simplifiant la géométrie du système de réception radiofréquence. Cette simplification est d'autant plus sensible pour des faibles intensités de champ magnétique. Cette simplification réduit de manière substantielle le coût du dispositif.

On réalise par ailleurs une structure qui est notamment moins encombrante, moins complexe, et plus économique que les dispositifs connus mentionnés précédemment.

Les moyens pour créer un champ magnétique homogène, parallèle à la surface ouverte, peuvent comporter un aimant permanent constitué d'un matériau tel que la ferrite, ou un alliage fer-terres rares, tel que le Fer-Néodyme-Bore. Avantageusement, l'homogénéité du champ peut être améliorée en utilisant un système dit "de shimming" constitué, soit de bobines de surface, soit de matériaux ferromagnétiques (fer) et/ou de petits aimants permanents.

Selon une alternative, les moyens pour créer un champ magnétique homogène comportent un aimant résistif constitué d'un fil de cuivre ou d'aluminium parcouru par un courant électrique.

Selon une autre alternative, les moyens pour créer un champ magnétique homogène comportent un aimant supraconducteur. De préférence, l'aimant supraconducteur est maintenu à basse température (typiquement, de l'ordre de 4 °K) au moyen par exemple d'un cryostat à l'hélium.

Selon une autre alternative encore, l'aimant est sur une partie de sa surface, directement en regard de la zone à examiner.

Dans la description qui suit, il sera fait référence aux dessins dans lesquels:
- la figure 1 représente de façon schématique un premier mode de réalisation du dispositif selon l'invention;
- la figure 2 représente de façon schématique un second mode de réalisation du dispositif selon l'invention;
- la figure 3 représente de façon schématique un troisième mode de réalisation du dispositif selon l'invention;
- la figure 4 représente un quatrième mode de réalisation du dispositif selon l'invention; et
- la figure 5 représente un dispositif selon l'invention monté sur un système de manipulation permettant d'amener le dispositif en regard d'une zone choisie.

Selon une caractéristique importante de la présente invention, les moyens pour créer le champ magnétique B₀, le système de gradients de champ, et le système d'émission/réception radiofréquence sont situés d'un même côté d'une surface ouverte tandis que le volume à examiner est situé de l'autre côté de la surface. Cette surface ouverte désigne la surface du dispositif destinée à être mise en regard du volume à observer. Au sens de la présente demande, on entend par « surface ouverte » une surface ne présentant aucun contour fermé, capable d'entourer le corps ou la partie du corps à examiner lorsque ce dernier est en position d'examen. Ainsi, l'objet n'est pas introduit dans un système l'enveloppant en tout ou partie, mais est disposé en regard de la surface du dispositif. Typiquement, une telle surface peut être réalisée de manière simple sous forme d'un plan. D'autres types de surface sont possibles telles que des surfaces légèrement bombées, ou des surfaces adaptées à la forme du corps ou de la partie du corps à étudier.

A titre de rappel théorique, il peut être intéressant de rappeler que les énergies magnétiques stockées dans un champ magnétique statique et dans un gradient de champ magnétique sont directement liées à au volume des systèmes les générant. Ainsi, plus les énergies mises en jeu seront faibles, plus la machine sera compacte, légère et bon marché. En effet, l'énergie magnétique stockée dans un champ magnétique est de l'ordre de B².V, où B représente l'intensité du champ directeur et V le volume sur lequel le champ est créé. D'autre part, ainsi que décrit dans la publication de Saint Jalmes et al, intitulée *"Design data for efficient axial gradient coils: application to NMR imaging"* publiée dans: Magnetic Resonance in Medecine, Vol. 2, p 245, 1985, la puissance électrique P nécessaire au fonctionnement des gradients de champ magnétique est fonction de G².D⁵/ΔT où G représente l'intensité du gradient de champ magnétique, D la dimension caractéristique de la bobine et ΔT sa durée de commutation. Ainsi, à intensités de champ et de gradient fixées, la minimisation des énergies stockées et commutées, impose de diminuer V et D, c'est à dire de diminuer le volume sur lequel les champs sont créés.

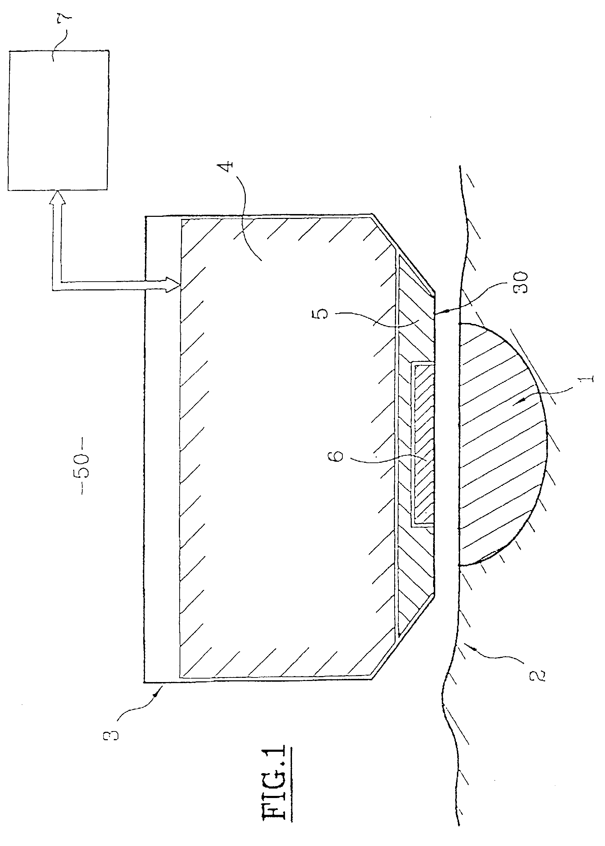

En se basant sur ces considérations théoriques, on réalise un dispositif (portant la référence 50) dont un premier mode de réalisation est illustré à la figure 1, et qui permet l'observation d'une zone ou partie 1 d'un corps ou d'un objet plus volumineux 2. Typiquement, ainsi que mentionné précédemment, le volume d'une telle zone peut varier de quelques cm³ à quelques centaines de cm³, et sa profondeur varie de quelques mm à quelques cm. Le système selon l'invention comprend à l'intérieur d'une enceinte 3 destinée à isoler le patient du système, un aimant dit de surface 4 apte à créer un champ magnétique statique d'intensité B₀ et d'uniformité spatiale suffisante pour permettre l'imagerie et/ou la spectroscopie sur le volume de la région d'intérêt 1. Selon une autre caractéristique essentielle de l'invention, le champ magnétique Bₒ est parallèle à la surface 30. Le dispositif 50 est positionné en regard du volume 1, l'examen étant réalisé au travers d'une surface 30 de l'enceinte 3, formant la surface ouverte telle que définie précédemment. La technologie utilisée pour la réalisation de l'aimant de champ principal dépend de l'intensité B₀ du champ, ainsi que du volume de la région d'intérêt.

A titre d'exemple, pour une puissance inférieure ou égale à 0,3 T on pourra utiliser un aimant permanent constitué d'un matériau ou d'un mélange de matériaux tels que les ferrites, ou un alliage fer-terres rares, tel que le Fer-Néodyme-Bore ou le Samarium-Cobalt. La canalisation des lignes de flux peut être effectuée au moyen de fer doux. Pour cette gamme de puissance, on pourra également utiliser un aimant résistif du type comportant un fil de cuivre ou d'aluminium parcouru par un courant électrique.

Pour une puissance de champ supérieure à 0,5 T, on utilisera de préférence un aimant du type supraconducteur. De préférence, un tel aimant supraconducteur est contenu à l'intérieur d'un système pour le maintenir à une température qui, typiquement, est de l'ordre de 4 °K. A titre d'exemple, on utilise un cryostat à l'hélium qui sera incorporé au dispositif.

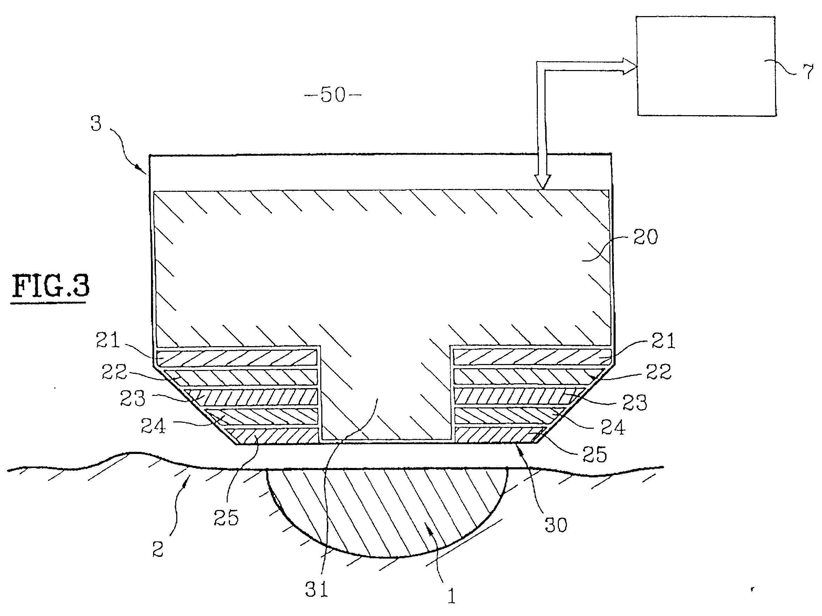

L'homogénéité du champ magnétique peut être améliorée en utilisant un système dit "de shimming" (21, figure 3), disposé par exemple de manière adjacente à l'aimant de surface (20, figure 3), et réalisé également sous forme d'un élément de surface. Un tel système peut être actif ou passif. Dans le cas d'un système actif, il est constitué de bobines de surface. Dans le cas d'un système passif, il est constitué de matériaux magnétiques et/ou de petits aimants permanents.

Le dispositif 50 comprend également un ensemble de bobines 5 permettant de créer des gradients de champ magnétique dans les trois directions de l'espace. A titre d'exemple, on utilise une technologie conforme à celle décrite dans le brevet des Etats-Unis d'Amérique 4 870 363 et selon lequel, le gradient de champ magnétique dans une direction de l'espace est constitué d'une bobine comprenant au moins deux enroulements, symétriques, par rapport à un plan s'étendant perpendiculairement à la direction du champ magnétique principal B₀, chacun des enroulements comprenant aux moins deux portions de tour situées dans un plan orthogonal à la direction du champ magnétique principal, espacées l'une de l'autre dans la direction du champ et reliées entre elles de manière appropriée. Avantageusement, et contrairement à certains des dispositifs discutés dans la première partie de la description, les gradients de champ sont substantiellement colinéaires à la direction du champ Bₒ.

Selon un autre exemple encore, les gradients de champ magnétique dans les trois directions de l'espace sont réalisés avantageusement au moyen d'une configuration conforme à celle décrite dans la thèse de Doctorat en Sciences de Melle Coeur-Joly soutenue le 8 décembre 1992 et intitulée « *Module à bobinages de gradients plats tridimensionnels et à antenne refroidie pour l'IRM à haute résolution spatiale »* et publiée en 1993 dans le Book of Abstracts, Vol 3, page 1361 du congrès de la Society of Magnetic Resonnance in Medecine. Typiquement, la configuration du gradient G_{z} est telle qu'elle offre une intensité de champ de 80 mT/m pour un courant de 40 A. La self inductance mesurée à 120 Hz est de 5,32 mH et la résistance mesurée en injectant un courant de 1 A est de 446 mΩ. Selon Y, le gradient G_{y} est de 70 mT/m pour un courant de 40 A. La self inductance est de 1,78 mH à 120 Hz et la résistance est de 325 mΩ pour 1 A. Selon l'axe X, le gradient Gₓ est de 35 mT/m pour un courant de 40 A. La self inductance est de 0,95 mH à 120 Hz et la résistance est de 283 mΩ pour 1 A. Le système complet à une longueur de 36 cm, une largeur de 25 cm et une épaisseur de 6 cm, pour un poids de l'ordre de 10 Kg. Il présente une linéarité de l'ordre de 93 % sur un volume cubique de 4 cm de côté.

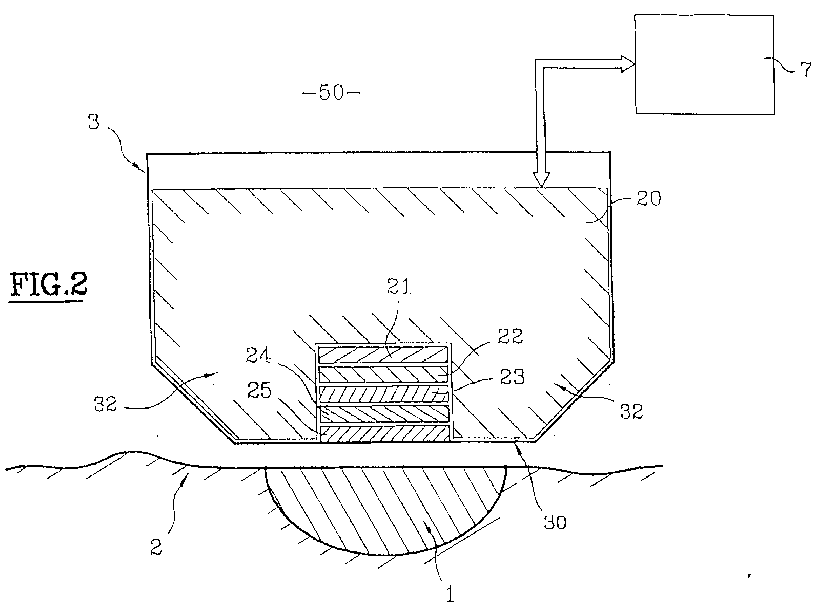

Un autre exemple encore de système de gradient de champ dans les trois directions de l'espace est décrit dans l'article intitulé « A novel Type of Surface Gradient Coil » publié dans Journal Of Magnetic Resonance 94, 471-485. Un tel système de gradient de champ est construit par exemple sur une plaque acrylique. Les enroulements 22, 23 (figures 2 et 3) pour les gradients selon les directions X et Z (Gₓ, G_{z}) sont disposés sur une face de la plaque, tandis que l'enroulement 24 pour le gradient selon la direction Y (G_{y}) est disposé sur l'autre face. Tous les fils sont recouverts d'une résine époxy. A titre d'exemple de géométrie, on utilise une enroulement de 20 tours pour les gradients selon les directions X et Y, et 30 tours pour l'enroulement G_{z}. Le diamètre du fil est de 0,7 mm pour Gₓ et 0,55 mm pour G_{y} et G_{z}. A titre indicatif, les enroulements sont constitués d'un fil de cuivre émaillé. Les inductances et les résistances sont de 1,8 mH et 1,5 Ω pour Gₓ, 1,6 mH et 1,5 Ω pour G_{y}, 1,2 mH et 1,5 Ω pour G_{z}. L'enroulement radiofréquence de surface 25 peut être disposé sur le système de gradient de champ, un écran faraday pouvant être disposé entre les deux de manière à éviter les interactions entre les deux. D'autres géométries sont bien évidemment envisageables en fonction de la puissance voulue. Selon une autre forme de réalisation, les bobines de gradients de champ magnétique sont réalisées sous forme d'un circuit imprimé.

En ce qui concerne l'enroulement d'émission/réception radiofréquence 25, il est disposé de manière adjacente aux bobines de gradient de champ 22, 23, 24, en regard de la zone 1 à observer. A titre d'exemple, de telles antennes de surface sont décrites par ACKERMAN et al, Nature 283, pp. 167-170, 1980. Un exemple de réalisation particulièrement adaptée à l'imagerie de la peau et fonctionnant dans le cas d'un champ magnétique Bₒ selon l'axe Z est également décrit dans la revue Radiology; 1996, pages 457-460 par J. Bittoun, H. Saint-Jalmes, B. Querleux et al. L'exemple décrit dans cette publication fonctionne en réception uniquement. Néanmoins, il suffit de supprimer le système d'écrétage constitué de deux diodes pour permettre son utilisation également en émission. La boucle de 3 cm de diamètre est réalisée à l'aide d'un tube de cuivre coaxial de 4 mm de diamètre. L'antenne est accordée à la fréquence de résonance à l'aide d'une capacité extérieure. Le conducteur interne est utilisé pour connecter l'antenne à un préamplificateur à travers une capacité, tout en mettant la masse au point milieu de la boucle. Une telle configuration minimise les pertes résistives dans l'antenne ainsi que les pertes diélectriques dans le patient.

Tous ces éléments du système selon l'invention sont commandés par une électronique associée à des moyens de calcul 7, du type ordinateur et dont la fonction est également d'acquérir les signaux et de les traiter pour former une image ou un spectre. Ces éléments sont du type de ceux utilisés de manière conventionnelle dans les machines de RMN, et par conséquent, ne nécessitent pas de description détaillée supplémentaire.

Les figures 2 et 3 illustrent deux autres modes de réalisation avantageux du dispositif 50 selon l'invention, et dans lesquels l'aimant 20 permettant la génération du champ magnétique principal est conçu de manière à avoir une partie de sa surface 31 directement en regard de la zone à observer 1. Ainsi, dans l'exemple représenté à la figure 3, l'aimant 20 a sa partie centrale 31 directement en regard de la zone à observer 1. Les autres organes (bobine de shimming 21, bobines de gradient de champ magnétique 22, 23, 24, et antennes d'émission/réception radiofréquence 25) du dispositif de RMN sont disposées tout autour, ou de part et d'autre, de la partie centrale 31. Dans l'exemple de la figure 2, l'aimant 20 définit une portion centrale évidée à l'intérieur de laquelle sont disposés les autres organes (bobine de shimming 21, bobines de gradient de champ magnétique 22, 23, 24, et antennes d'émission/réception radiofréquence 25) du dispositif de RMN. De cette manière, l'aimant est en regard de la surface ouverte, sur une zone périphérique 32 de ladite surface.

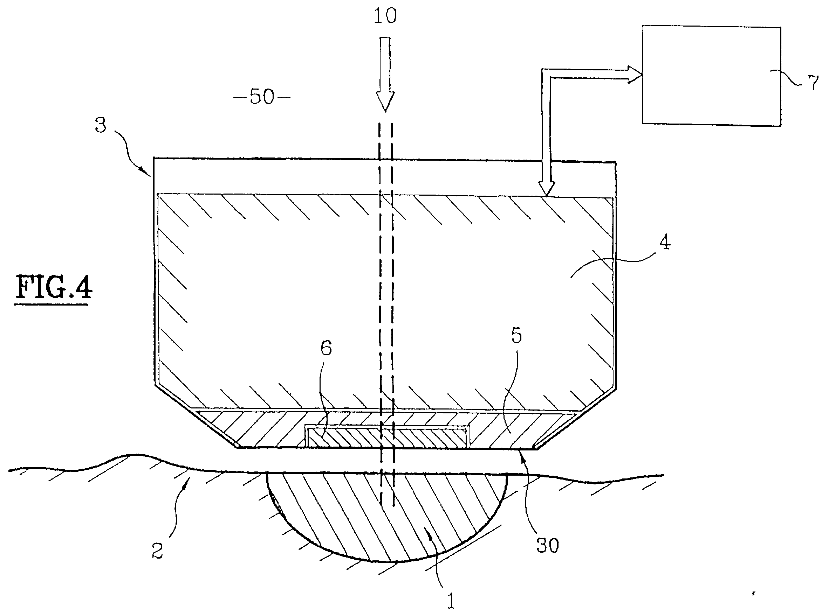

La figure 4 représente un dispositif 50 similaire à celui de la figure 1 mais dans lequel un passage d'instruments 10 est ménagé dans l'axe du système de champs magnétiques, permettant ainsi à un chirurgien d'opérer (une biopsie, par exemple) tout en ayant une image de la zone ou est pratiquée l'intervention. Une telle caractéristique peut être envisagée de la même manière sur les dispositifs des figures 2 et 3.

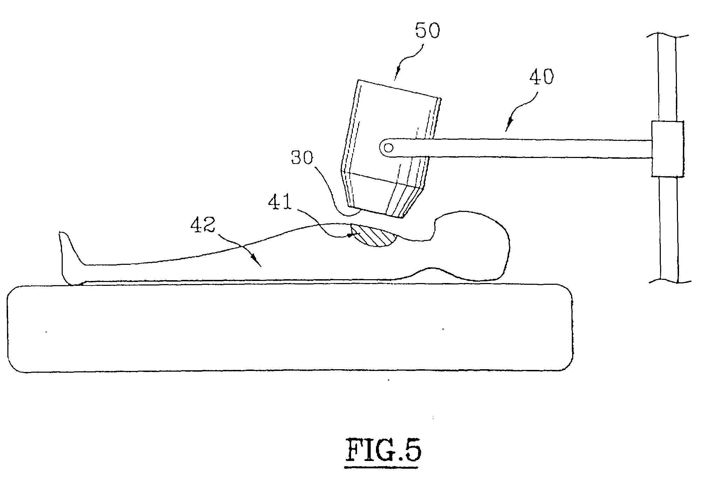

La figure 5 illustre un avantage important du dispositif 50 selon la présente invention. En effet, en raison de sa compacité et de ses relativement faibles encombrement et poids (typiquement, inférieur à 500 kg), le dispositif d'examen peut être monté sur un bras de manipulation 40 afin d'être amené aisément par le médecin directement en regard d'une zone 41 d'un patient 42. Le patient 42 est allongé sur une table d'examen, rendant ainsi l'examen plus confortable, à la fois pour le patient et le praticien. Ce type d'appareil, de par sa structure complètement ouverte, est également particulièrement adapté à l'examen de patients souffrant de claustrophobie. De la même manière, le dispositif d'examen peut être monté à poste fixe, le patient, en position assise par exemple, étant alors déplacé par rapport au dispositif.

Le dispositif selon l'invention a été décrit en faisant référence à des modes de réalisation avantageux de l'invention. Il est évident que des variantes peuvent y être apportées sans s'écarter de l'esprit de l'invention telle que revendiquée ci-après.

## Revendications

1. Dispositif d'examen (50) d'un volume (1) de faible profondeur, par résonance magnétique nucléaire, comportant des moyens (4, 21) pour créer un champ magnétique statique homogène B₀ dans lequel est placé le volume à examiner, un système de gradients de champ (5, 22, 23, 24) pour créer des gradients de champ magnétique dans les trois directions de l'espace; un système d'émission/réception radiofréquence (6, 25), les moyens pour créer le champ magnétique B₀, le système de gradients de champ, et le système d'émission/réception radiofréquence étant situés d'un même côté d'une surface ouverte (30) tandis que le volume à examiner est situé de l'autre côté de la surface, caractérisé en ce que ledit champ magnétique B₀ a une direction parallèle à ladite surface ouverte (30).

2. Dispositif d'examen selon la revendication 1 caractérisé en ce qu'il comprend en outre un système dit "de shimming" (21) pour améliorer l'homogénéité du champ magnétique Bo, ledit système de shimming (21) étant placé du côté de la surface ouverte opposé au volume à examiner.

3. Dispositif d'examen selon la revendication 2 caractérisé en ce que le système de shimming est constitué soit de bobines, soit de matériaux ferromagnétiques (fer) et/ou de petits aimants permanents.

4. Dispositif d'examen selon l'une quelconque des revendications 1 à 3 caractérisé en ce que les moyens pour créer un champ magnétique homogène (4, 21) comportent un aimant permanent.

5. Dispositif selon la revendication 4 caractérisé en ce que ledit aimant est constitué d'un matériau ou d'un mélange de matériaux tels que la ferrite, ou un alliage fer-terres rares, tel que le Fer-Néodyme-Bore.

6. Dispositif selon l'une quelconque des revendications 1 à 3 caractérisé en ce que les moyens pour créer un champ magnétique homogène (4, 21) comportent un aimant résistif constitué d'un fil de cuivre ou d'aluminium parcouru par un courant électrique.

7. Dispositif selon l'une quelconque des revendications 1 à 3 caractérisé en ce que les moyens pour créer un champ magnétique homogène (4, 21) comportent un aimant du type supraconducteur.

8. Dispositif selon la revendication 7 caractérisé en ce que l'aimant supraconducteur est refroidi à une température de l'ordre de 4 °K au moyen d'un cryostat à l'hélium.

9. Dispositif selon l'une quelconque des revendications 1 à 8 caractérisé en ce que le système permettant de créer un gradient de champ dans les trois directions de l'espace comporte un agencement de trois bobines (22, 23, 24) constituées d'un fil de cuivre émaillé.

10. Dispositif selon l'une quelconque des revendications 1 à 8 caractérisé en ce que le système permettant de créer un gradient de champ magnétique dans les trois directions de l'espace est réalisé sous forme d'un circuit imprimé.

11. Dispositif selon l'une quelconque des revendications 1 à 10 caractérisé en ce que l'aimant est au moins en partie (31, 32), directement en regard du volume à examiner.

12. Dispositif selon la revendication 11 caractérisé en ce que l'aimant est directement en regard du volume à examiner sur une partie centrale (31) de ladite surface ouverte (30).

13. Dispositif selon la revendication 11 caractérisé en ce que l'aimant est directement en regard du volume à examiner sur une partie périphérique (32) de ladite surface ouverte (30).

14. Dispositif selon l'une quelconque des revendications précédentes caractérisé en ce qu'il comporte un passage (10) dans l'axe du dispositif et apte à permettre le passage d'un outil pour accéder au volume examiné (1).

15. Dispositif selon l'une quelconque des revendications précédentes caractérisé en ce que ledit volume (1) est observé in-vivo et est constitué d'une partie de peau humaine, d'un oeil, d'une oreille, ou d'une partie superficielle du cerveau.
